# EUROPEAN PATENT APPLICATION

(11) **EP 4 812 006 A2**
(43) Date of publication of application: **23.09.2026**
(21) Application number: 26164714.3
(22) Date of filing: 13.03.2026
(51) Int. Cl.: H10W 44/00, H01F 5/00

(54) **CUSTOM RF INDUCTORS FOR RF MODULES**

(30) Priority: 20.03.2025 US 202563774819 P; 10.11.2025 US 202519384478
(71) Applicant: Qorvo US, Inc., Greensboro, NC 27409 (US)
(72) Inventor: KOLCHUZHIN, Vladimir, Greensboro, 27409 (US); KRYSHTOPIN, Andriy, Greensboro, 27409 (US); LOIZOU, Loizos, Greensboro, 27409 (US)
(74) Representative: D Young & Co LLP

(57) **Abstract**

Disclosed herein are embodiments of a radio frequency (RF) package that include a package laminate and a surface mount device mounted to a mounting surface of the package laminate. The package laminate includes a first laminate substrate and a metallic structure integrated with the first laminate substrate. An electronic component is mounted to the mounting surface of the first laminate substrate. The surface mount device includes a second laminate substrate and an inductor integrated with the second laminate substrate. A bounded physical area is defined by at least one of a surface of the electronic component and the metallic structure that defines a boundary of the bounded physical area. The surface mount device is dimensioned so as to fit within the bounded physical area. In this manner, the surface mount device allows for a more compact RF package with a higher quality factor.

## Description

### Related Applications

This application claims the benefit of provisional patent application serial number 63/774,819, filed March 20, 2025, and of the patent application serial number 19/384,478 filed November 10, 2025, the disclosure of each of which is hereby incorporated herein by reference in its entirety.

### Field

This disclosure relates generally to surface mount devices and, in particular, to surface mount devices that include inductor components in radio frequency (RF) packages.

### Background

The trends in mobile device electronics (particularly in radio frequency (RF) front-end (FE) modules) are driven by the demand for increased functionality in smaller form factors. This trend has been further intensified with the introduction of 5th Generation (5G) technology. To support the extensive carrier aggregations and bandwidth enhancements required for 5G, these modules now incorporate a greater number of acoustic filters (such as bulk acoustic wave (BAW) filters or surface acoustic wave (SAW) filters), resulting in large and intricate multiplexer networks. These networks are further complemented by switches, power amplifiers (PAs), and low-noise amplifiers (LNAs).

This pursuit of enhanced content and miniaturization, coupled with the need to maintain low costs, often pushes against the physical limitations of processing, packaging, and manufacturing. Moreover, it frequently encounters various technological barriers in packaging. The drive for more functionality in smaller form factors can potentially impact system performance, presenting a significant challenge for engineers and manufacturers.

To address these challenges, the industry is adopting innovative solutions. Advanced packaging techniques (such as a double-sided molded ball grid array (DSMBGA) and a double-sided molded land grid array (DSMLGA) are being employed to increase integration levels. Manufacturers are also developing new circuit designs to reduce RF noise, improve efficiency, and enable the coexistence of multiple radio transmitters within the confined space of modern smartphones. Additionally, the use of advanced materials in acoustic filters and other components is helping to improve performance while maintaining compact sizes. Filtering components (such as the size and spacing consumed by inductive components) are particularly important in providing compact RF packages with the appropriate filtering capabilities.

### Summary

Particular aspects are set out in the appended independent claims. Various optional embodiments are set out in the dependent claims.

Embodiment 1. A radio frequency (RF) package, including: a package laminate, including: a first laminate substrate defining a mounting surface; and a metallic structure integrated with the first laminate substrate; an electronic component mounted to the mounting surface of the first laminate substrate; a surface mount device mounted to the mounting surface, the surface mount device including: a second laminate substrate; and an inductor integrated with the second laminate substrate; and a bounded physical area defined by at least one of a surface of the electronic component and the metallic structure that defines a boundary of the bounded physical area, the surface mount device being dimensioned so as to fit within the bounded physical area.

Embodiment 2. The RF package of embodiment 1, wherein: the bounded physical area is bound by one or more traces formed by the metallic structure; the mounting surface is a first mounting surface; the second laminate substrate defines a second mounting surface; and the surface mount device being dimensioned so as to fit within the bounded physical area includes having the second mounting surface being dimensioned so as to fit within the bounded physical area.

Embodiment 3. The RF package of embodiment 2, wherein: the metallic structure defines a first inductor coil; and the surface mount device is mounted to the first mounting surface over the first inductor coil.

Embodiment 4. The RF package of embodiment 3, wherein the inductor defines a second inductor coil, wherein a first shape of the first inductor coil is a same shape as a second shape of the second inductor coil.

Embodiment 5. The RF package of embodiment 1, wherein: the bounded physical area is bound by a first vertical surface of the electronic component; the surface mount device defines a second vertical surface; and the surface mount device being dimensioned so as to fit within the bounded physical area includes having the second vertical surface being dimensioned so as to fit within the first vertical surface.

Embodiment 6. The RF package of embodiment 5, wherein the electronic component includes an acoustic filter.

Embodiment 7. The RF package of embodiment 1, wherein the inductor includes a plurality of inductor coils, each of the plurality of inductor coils is formed in a different metallic layer within the second laminate substrate.

Embodiment 8. The RF package of embodiment 1, wherein the surface mount device further includes a metallic Faraday cage that surrounds the inductor.

Embodiment 9. The RF package of embodiment 1, wherein: the inductor is a first inductor; and the surface mount device further includes a second inductor configured to be electromagnetically coupled to the first inductor so as to form a transformer or a balun.

Embodiment 10. The RF package of embodiment 1, further including an overmold formed over the mounting surface so as to cover the surface mount device.

Embodiment 11. A method of manufacturing a radio frequency (RF) package, including: providing a laminate having an inductor integrated into the laminate; dicing the laminate to provide form a surface mount device with a device laminate that includes the inductor, the surface mount device being dimensioned so as to fit within a bounded physical area; mounting an electronic component on a mounting surface of a package laminate, a metallic structure being integrated into the package laminate; and mounting the surface mount device to the mounting surface, wherein the bounded physical area is defined by at least one of a surface of the electronic component and the metallic structure that defines a boundary of the bounded physical area.

Embodiment 12. A user element including a radio frequency (RF) package, the RF package including: a package laminate, including: a first laminate substrate defining a mounting surface; and a metallic structure integrated with the first laminate substrate; an electronic component mounted to the mounting surface of the first laminate substrate; a surface mount device mounted to the mounting surface, the surface mount device including: a second laminate substrate; and an inductor integrated with the second laminate substrate; and a bounded physical area defined by at least one of a surface of the electronic component and the metallic structure that defines a boundary of the bounded physical area, the surface mount device being dimensioned so as to fit within the bounded physical area.

Embodiment 13. The user element of embodiment 12, wherein: the bounded physical area is bound by one or more traces formed by the metallic structure; the mounting surface is a first mounting surface; the second laminate substrate defines a second mounting surface; and the surface mount device being dimensioned so as to fit within the bounded physical area includes having the second mounting surface being dimensioned so as to fit within the bounded physical area.

Embodiment 14. The user element of embodiment 13, wherein: the metallic structure defines a first inductor coil; and the surface mount device is mounted to the first mounting surface over the first inductor coil.

Embodiment 15. The user element of embodiment 14, wherein the inductor defines a second inductor coil, wherein a first shape of the first inductor coil is a same shape as a second shape of the second inductor coil.

Embodiment 16. The user element of embodiment 12, wherein: the bounded physical area is bound by a first vertical surface of the electronic component; the surface mount device defines a second vertical surface; and the surface mount device being dimensioned so as to fit within the bounded physical area includes having the second vertical surface being dimensioned so as to fit within the first vertical surface.

Embodiment 17. The user element of embodiment 16, wherein the electronic component includes an acoustic filter.

Embodiment 18. The user element of embodiment 12, wherein the inductor includes a plurality of inductor coils, each of the plurality of inductor coils is formed in a different metallic layer within the second laminate substrate.

Embodiment 19. The user element of embodiment 12, wherein the surface mount device further includes a metallic Faraday cage that surrounds the inductor.

Embodiment 20. The user element of embodiment 12, wherein: the inductor is a first inductor; and the surface mount device further includes a second inductor configured to be electromagnetically coupled to the first inductor so as to form a transformer or a balun.

Embodiment 21. A method of designing a surface mount device, the method including: defining an available surface area for fitting an in silico surface mount device based on adjacent in silico components on the an in silico package substrate of an in silico RF package; identifying in silico grounds and components of an in silico metallic structure surrounding the available surface area so that a performance of an in silico inductor of the in silico surface mount device can be optimized by reducing parasitic capacitance; performing electromagnetic simulations of in silico surface mount devices from a data library to select one or more candidate in silico surface mount devices based on the electromagnetic simulations. wherein each of the one or more candidate in silico surface mount devices has been dimensioned to fit within the available physical area; and empirically verifying at least one physical surface mount device that is formed in accordance with at least one of the one or more candidate in silico surface mount devices to determine whether the at least one physical surface mount device meets the design specifications.

Those skilled in the art will appreciate the scope of the present disclosure and realize additional aspects thereof after reading the following detailed description of the preferred embodiments in association with the accompanying drawing figures.

### Brief Description of the Drawing Figures

The accompanying drawing figures incorporated in and forming a part of this specification illustrate several aspects of the disclosure and, together with the description, serve to explain the principles of the disclosure.
FIG. 1 illustrates a radio frequency (RF) package, in accordance with some embodiments;
FIGs. 2A and 2B illustrate a surface mount device, in accordance with some embodiments;
FIG. 3 illustrates another surface mount device, in accordance with some embodiments;
FIG. 4 illustrates still another surface mount device, in accordance with some embodiments;
FIG. 5 illustrates yet another surface mount device, in accordance with some embodiments;
FIGs. 6A - 6E illustrate procedures for manufacturing different embodiments of an RF package, in accordance with some embodiments;
FIG. 7 is a flow chart of a method of designing a surface mount device, in accordance with some embodiments;
FIG. 8 is a computer device, in accordance with some embodiments; and
FIG. 9 illustrates a user element in accordance with some embodiments.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It should be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It should also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It should be understood that, although the terms "upper," "lower," "bottom," "intermediate," "middle," "top," and the like may be used herein to describe various elements, these elements should not be limited by these terms. These terms are only used to distinguish one element from another. For example, a first element could be termed an "upper" element and, similarly, a second element could be termed an "upper" element depending on the relative orientations of these elements, without departing from the scope of the present disclosure.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having meanings that are consistent with their meanings in the context of this specification and the relevant art and will not be interpreted in an idealized or overly formal sense unless expressly so defined herein.

Embodiments of a radio frequency (RF) package are disclosed. The RF package includes a package laminate and various RF devices mounted on the package laminate. At least one of these devices is a surface mount device that includes one or more inductors. More specifically, the inductors are laminate-based inductors. The dimensions of the surface mount devices can be selected in order to fit the surface mount devices within a bounded physical area on the package laminate. In this manner, the surface mount devices can be provided to fit in custom spaces of the RF package while providing a relatively high Quality- (Q-) factor.

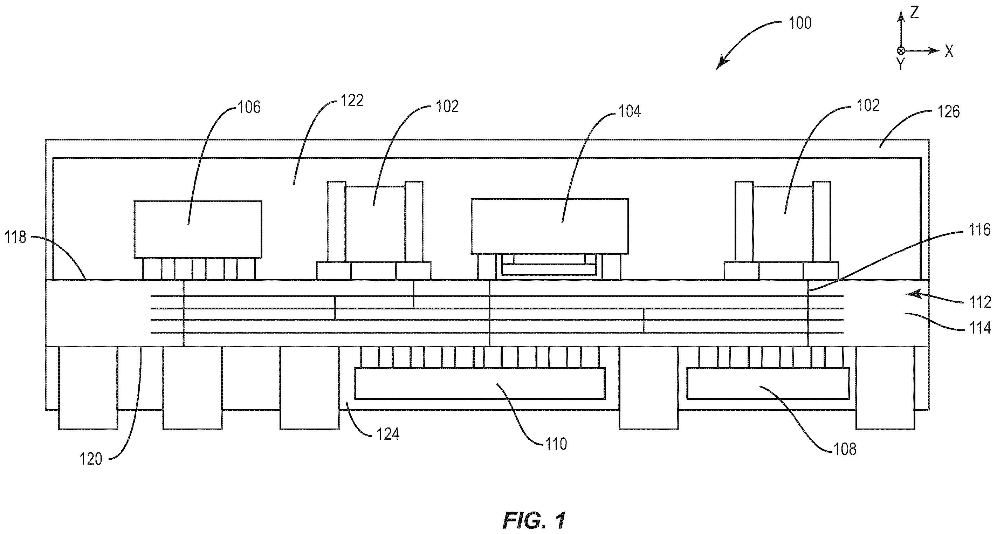

FIG. 1 illustrates an RF package 100, in accordance with some embodiments.

The RF package 100 is configured to house one or more electronic components. In this embodiment, the electronic components include surface mount devices 102, an acoustic filter 104, a power amplifier (PA) 106, a low-noise amplifier (LNA) 108, and a switch device 110, all of which are parts of an RF circuit (e.g., RF front-end (FE) circuitry). Other embodiments of the RF package 100 may have any combination of electronic components for an RF circuit. In this embodiment, each of the electronic components includes a substrate as well as conductive components. Examples of the surface mount devices 102 include inductors, external connectors, and a laminate, as will be explained in further detail below. The acoustic filter 104 may include a piezoelectric substrate and conductive components. The piezoelectric substrate is used to form acoustic resonators in an RF filter circuit while the conductive components may include external connectors. Examples of the acoustic filter 104 may include a bulk-acoustic wave (BAW) filter, a surface acoustic wave (SAW) filter, and/or the like.

The PA 106 is formed in a semiconductor substrate (e.g., a Gallium Arsenide (GaAs) substrate) and includes conductive components. The conductive components include external connectors. The LNA 108 is formed in a semiconductor substrate (e.g., a Silicon on Insulator (SOI) substrate) and includes conductive components. The conductive components may include external connectors. The switch device 110 is formed in a semiconductor substrate (e.g., a SOI substrate) and includes conductive components. The conductive components may include external connectors.

The RF package 100 includes a package laminate 112. The package laminate 112 includes a laminate substrate 114 (forming a body of the package laminate 112). Different types of laminates that may be used to form the laminate substrate 114 include epoxy-based laminates (e.g., flame resistant (FR)-4 laminates), high glass transition temperature epoxy laminates, Bismaleimide-Triazine (BT) laminates, polyimide laminates, teflon (PTFE) laminates, copper clad laminates (CCL), and halogen-free laminates. A metallic structure 116 is integrated with the laminate substrate 114. In some embodiments, the metallic structure 116 includes various metallic layers.

The Z-axis is oriented with respect to the direction of stacking. The Z-axis is a vertical axis and any vertical plane includes a line parallel to the Z-axis. The X-axis is orthogonal to the Z-axis and the Y-axis is orthogonal to both the Z-axis and the X-axis. Any horizontal plane includes a line parallel to the X-axis and a line parallel to the Y-axis. Any vertical plane has a line parallel to the Z-axis and a line parallel to either the X-axis or the Y-axis.

Metallic layers in the metallic structure 116 are stacked with respect to the Z-axis, but each extend in a horizontal plane. The metallic layers may be connected by metallic vias that vertically connect the structures formed by the metallic layers. Furthermore, the metallic structure 116 may include external connectors that allow the RF package 100 to be connected to externally. For example, the external connectors may be connected to a printed circuit (PC) board.

The laminate substrate 114 defines an upper mounting surface 118 and a lower mounting surface 120 that is opposite to the upper mounting surface 118. In other embodiments, the laminate substrate 114 only includes one mounting surface. The surface mount devices 102, the acoustic filter 104, and the PA 106 are mounted to the upper mounting surface 118 and, thereby, are connected to the metallic structure 116. The LNA 108 and the switch device 110 are mounted to the lower mounting surface 120 and, thereby, are connected to the metallic structure 116. Note that, in some embodiments, capacitors, inductor coils, and other passive electronic components may be formed by the metallic structure 116.

In this embodiment, an overmold 122 is formed over the upper mounting surface 118 so as to cover the surface mount devices 102, the acoustic filter 104, and the PA 106. An undermold 124 is formed over the lower mounting surface 120 to cover the LNA 108 and the switch device 110. The overmold 122 and the undermold 124 may be formed from a dielectric material such as elastomeric materials, thermoplastic materials, and/or thermoset materials. An conductive shield 126 covers the overmold 122. In contrast, the external connectors for external connections outside the RF package 100 are exposed from the undermold 124.

The surface mount devices 102 incorporate discrete inductors that are dimensioned so as to fit within a bounded physical area. For instance, the metallic structure 116 may define a bounded area (such as a coil or traces) that at least partially bound an area, such as an area of the upper mounting surface 118. The surface mount devices 102 may be dimensioned to fit within these bounded physical areas. In another example, an electronic component (such as the acoustic filter 104) may define a surface and one of the surface mount devices 102 may be dimensioned so as to fit within the bounded physical area. As explained below, the make-up of the surface mount devices 102 significantly enhance the performance of RF FE modules while simultaneously boosting the system functionality and package density.

Among the many benefits of the RF circuit described above and herein include improved RF performance attributed to the increased Q-factor of inductors provided in the surface mount devices 102, reduced overall size of the RF package 100, and potential cost savings in manufacturing and materials. Additionally, during the design phase, the design of the surface mount device 102 may optimize system isolation and leakage performance by carefully selecting the geometry and design of the surface mount device 102.

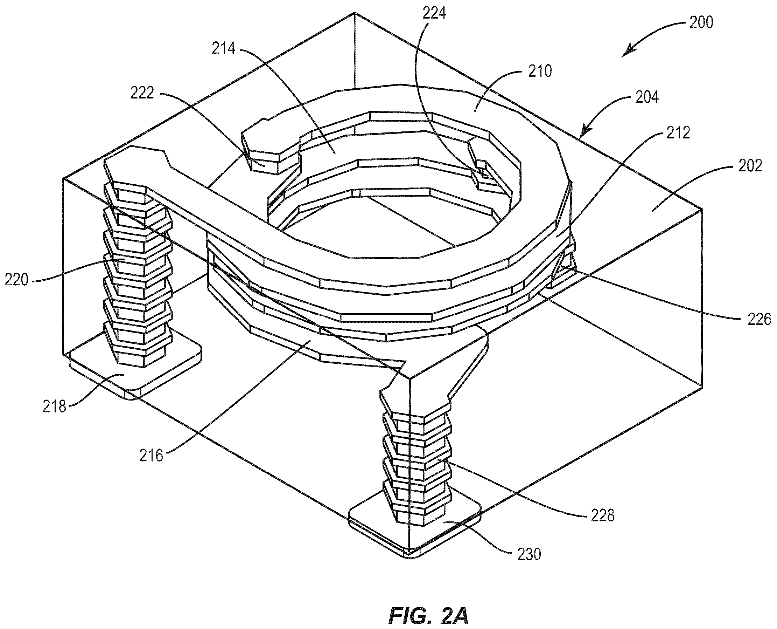

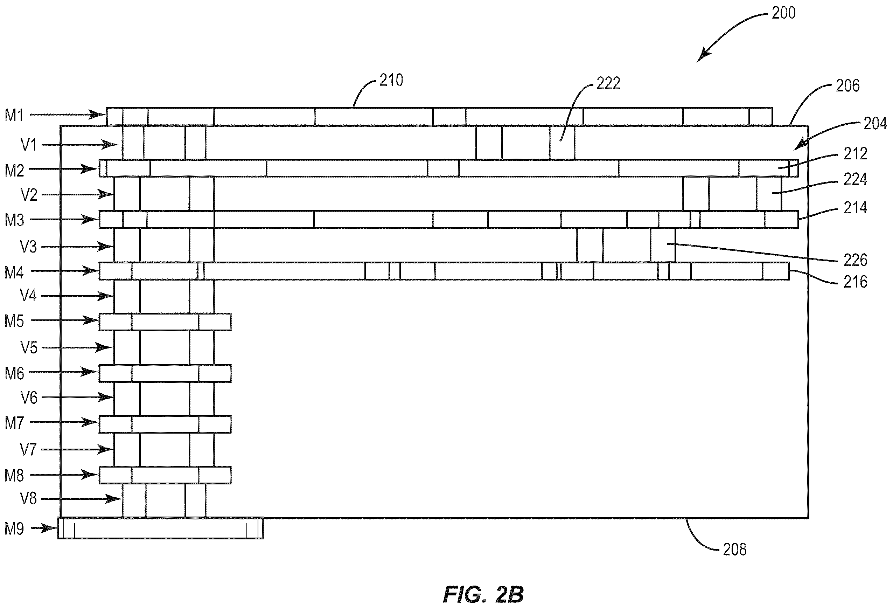

FIGs. 2A and 2B illustrate a surface mount device 200, in accordance with some embodiments.

Specifically, FIG. 2A illustrates a perspective transparent top view of the surface mount device 200 while FIG. 2B illustrates a cross-sectional view of the surface mount device 200. One or more of the surface mount devices 102 shown in FIG. 1 may be provided in the same manner as the surface mount device 200 shown in FIGs. 2A and 2B.

The surface mount device 200 includes a laminate substrate 202 and an inductor 204 integrated with the laminate substrate 202. More specifically, the laminate substrate 202 has 9 metal layers M1-M9 (See FIG. 2B) integrated into the laminate substrate 202. Different types of laminates that may be used to form the laminate substrate 202 include epoxy-based laminates (e.g., FR-4), high glass transition temperature epoxy laminates, BT laminates, PTFE laminates, CCL, and halogen-free laminates.

The metal layers M1-M9 are stacked in a vertical direction and conductive via layers V1-V8 (See FIG. 2B) are provided between adjacent ones of the metal layers M1-M9 in order to connect structures formed by the metal layers M1-M9. The metal layer M1 is formed on an upper surface 206 (See
FIG. 2B) of the laminate substrate 202 while the metal layer M9 is formed on a lower surface 208 (See FIG. 2B) of the laminate substrate 202. The metal layers M2-M8 and the conductive via layers V1-V8 are internal to the laminate substrate 202. It should be noted that, in other embodiments, the surface mount device 200 may have any number of metal layers and conductive via layers.

The inductor 204 includes four inductor coils 210, 212, 214, 216. In this embodiment, each of the inductor coils 210, 212, 214, 216 is circular but, in other embodiments, the inductor coils 210, 212, 214, 216 may be of any suitable shape. The inductor coil 210 is formed in the metal layer M1. An input/output terminal 218 (See FIG. 2A) for the inductor coil 210 is formed in the metal layer M9. The input/output terminal 218 is part of a pillar stack 220 (See FIG. 2A) that connects to the inductor coil 210. The inductor coil 210 is connected to the inductor coil 212 by a conductive via 222 in the conductive via layer V1. The inductor coil 212 is formed in the metal layer M2. The inductor coil 212 is connected to the inductor coil 214 by a conductive via 224 in the conductive via layer V2. The inductor coil 214 is formed in the metal layer M3. The inductor coil 214 is connected to the inductor coil 216 by a conductive via 226 in the conductive via layer V3. The inductor coil 216 is formed in the metal layer M4. A pillar stack 228 connects the inductor coil 216 to an input/output terminal 230 formed in the metal layer M9.

The surface mount device 200 can have customized dimensions in order to fit within a desired bounded physical area while having an improved
Q-factor. In one embodiment, the metal layers M1-M9 are 10 micrometers (µm) thick along the Z-axis and the dielectric material between the metal layers M1-M9 is 21 µm thick with a permittivity of 3.5 Farad per meter (F/m). The width of the inductor coils 210, 212, 214, 216 in the X-Y plane is 35 µm. Simulations showed that the inductor 204 has an inductance of 2.1 Nanohenries (nH) and a Q-factor equal to 38 at 2 Gigahertz (GHz).

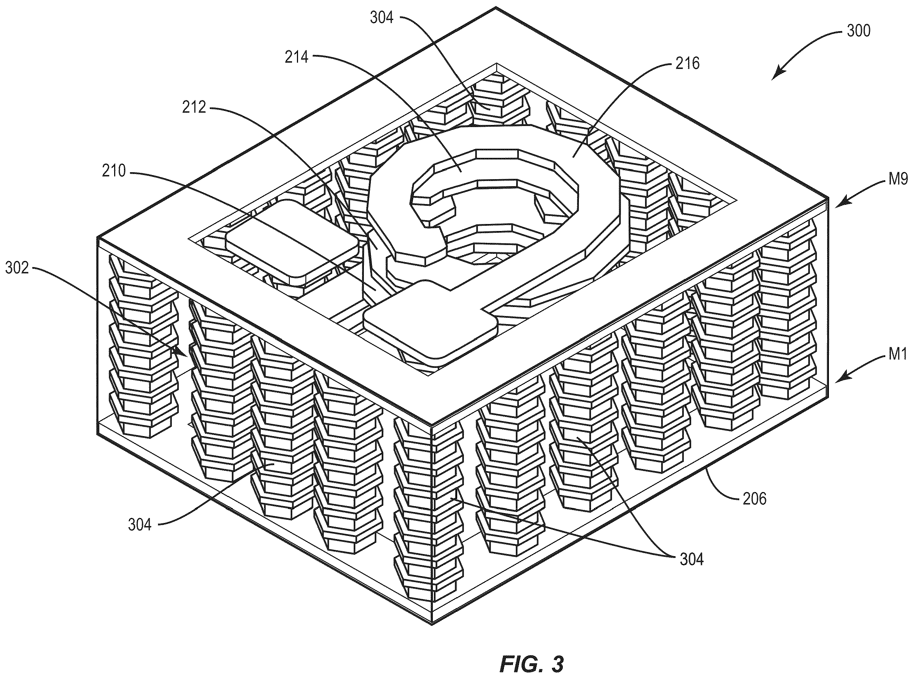

FIG. 3 illustrates another surface mount device 300, in accordance with some embodiments.

One or more of the surface mount devices 102 shown in FIG. 1 may be provided in the same manner as the surface mount device 300. The surface mount device 300 is the same as the surface mount device 200 shown in FIGs. 2A and 2B, expect that the inductor 204 shown in FIGs. 2A and 2B is surrounded by a Farraday cage 302 and the inductor coils 210, 212, 214, 216 shown in FIGs. 2A and 2B are formed in the metal layers M6-M9 (See FIG. 2B - the metal layers M1, M9 are specifically labeled in FIG. 3 to demonstrate the orientation of the surface mount device 300) instead of the metal layers M1-M4 (See FIG. 2B) while the conductive via 222 shown in FIGs. 2A and 2B is in the conductive via layer V6 (See FIG. 2B), the conductive via 224 shown in FIGs. 2A and 2B is in the conductive via layer V7 (See FIG. 2B), and the conductive via 226 shown in FIGs. 2A and 2B is in the conductive via layer V8 (See FIG. 2B). The Farraday cage 302 is formed by conductive pillar stacks 304 (not all labeled for the sake of clarity) wherein each of the conductive pillar stacks 304 is formed by the metal layers M1-M9 and the conductive via layers V1-V8. In this embodiment, the Farraday cage 302 has a square cross section in the X-Y plane. Other embodiments of the Farraday cage 302 may have any suitable shape.

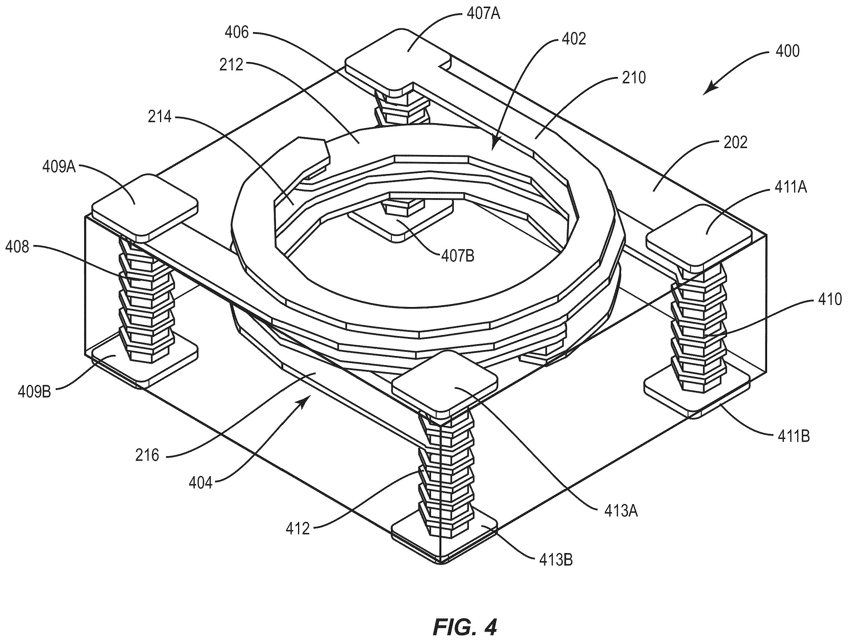

FIG. 4 illustrates still another surface mount device 400, in accordance with some embodiments.

The surface mount device 400 includes the laminate substrate 202 and the inductor coils 210, 212, 214, 216 described above with respect to FIGs. 2A and 2B. However, the inductor coils 210, 212, 214, 216 are connected in a different manner in FIG. 4 than in FIGs. 2A and 2B.

More specifically, the conductive via 222 is provided and the conductive via 226 is provided, both as described in FIGs. 2A and 2B. However, the conductive via 224 shown in FIGs. 2A and 2B is not provided in FIG. 4. As such, the inductor coils 210, 212 are connected to one another to form an inductor 402 and the inductor coils 214, 216 are connected to one another to form an inductor 404. The inductor coils 212, 214 are not connected to one another. Instead, the inductors 402, 404 are electromagnetically coupled through magnetic and/or electric field flux that is generated once currents are generated through the inductors 402, 404 and therefore form a transformer or BALUN.

In this embodiment, a conductive pillar 406 is formed by the metal layers M1-M9 and the conductive via layers V1-V8, wherein the conductive pillar 406 includes an input/output terminal 407A at the metal layer M1 and an input/output terminal 407B at the metal layer M9. The conductive pillar 406 is connected to the inductor coil 210.

Additionally, a conductive pillar 408 is formed by the metal layers M1-M9 and the conductive via layers V1-V8, wherein the conductive pillar 408 includes an input/output terminal 409A at the metal layer M1 and an input/output terminal 409B at the metal layer M9. The conductive pillar 408 is connected to the inductor coil 212. In this manner, RF signals can be applied to the inductor 402 through the conductive pillars 406, 408.

In this embodiment, a conductive pillar 410 is formed by the metal layers M1-M9 and the conductive via layers V1-V8, wherein the conductive pillar 410 includes an input/output terminal 411A at the metal layer M1 and an input/output terminal 411B at the metal layer M9. The conductive pillar 410 is connected to the inductor coil 214.

Additionally, a conductive pillar 412 is formed by the metal layers M1-M9 and the conductive via layers V1-V8, wherein the conductive pillar 412 includes an input/output terminal 413A at the metal layer M1 and an input/output terminal 413B at the metal layer M9. The conductive pillar 412 is connected to the inductor coil 216. In this manner, RF signals can be applied to the inductor 404 through the conductive pillars 410, 412. The surface mount device 400 thus includes a transformer or a balun formed from the inductors 402, 404.

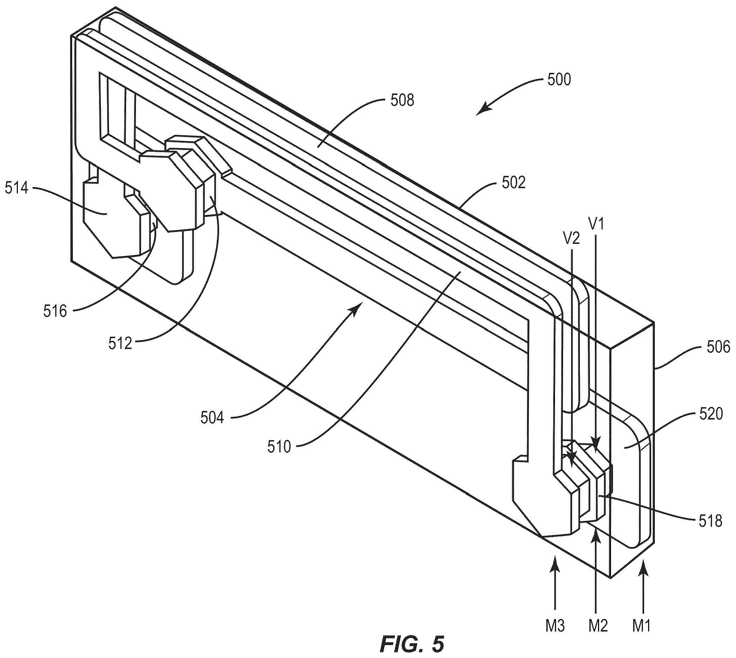

FIG. 5 illustrates yet another surface mount device 500, in accordance with some embodiments.

One or more of the surface mount devices 102 shown in FIG. 1 may be provided in the same manner as the surface mount device 500. The surface mount device 500 includes a laminate 502 and an inductor 504 formed in the laminate 502.

The metal layers M1-M3 are integrated with the laminate 502. The metal layer M1 is formed on a surface 506 of the laminate 502 while the metal layers M2, M3 are internal in the laminate 502. An inductor coil 508 is formed in the metal layer M2 and an inductor coil 510 is formed in the metal layer M3. A conductive via 512 in the conductive via layer V2 connects the inductor coil 508 and the inductor coil 510. A conductive pillar 514 has an input/output terminal 516 where the conductive pillar 514 is connected to the inductor coil 508. A conductive pillar 518 has an input/output terminal 520 where the conductive pillar 518 is connected to the inductor coil 510.

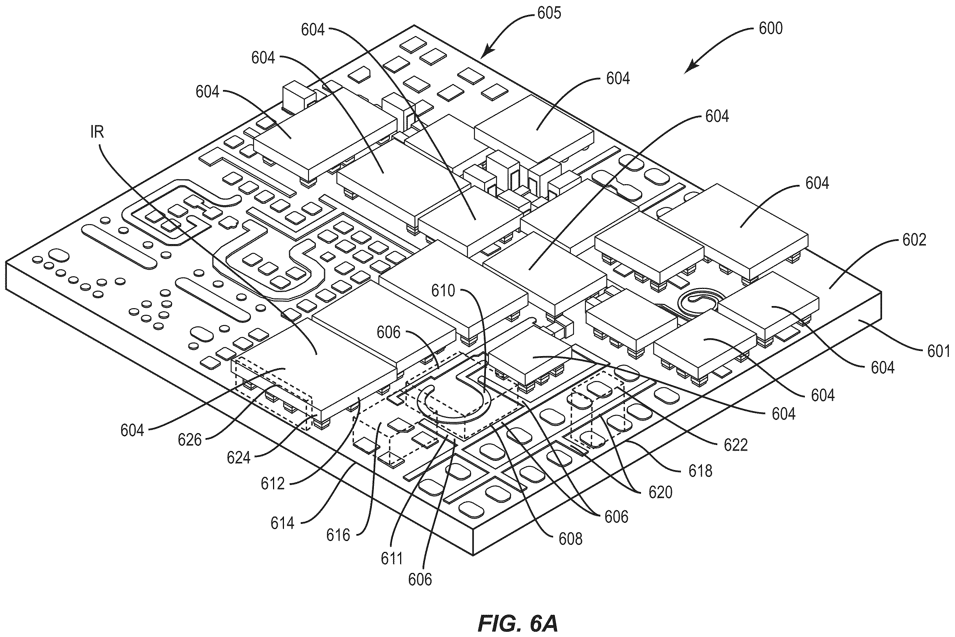

FIGs. 6A - 6E illustrate procedures for manufacturing different embodiments of an RF package, in accordance with some embodiments.

In FIG. 6A, a package laminate 600 is provided. In some embodiments, the package laminate 600 is the package laminate 112 shown in FIG. 1. The package laminate 600 includes a laminate substrate 601 that defines a mounting surface 602. In some embodiments, the laminate substrate 601 is the laminate substrate 114 shown in FIG. 1 and the mounting surface 602 is the upper mounting surface 118 shown in FIG. 1. Various electronic components 604 are mounted to the mounting surface 602. For example, the electronic components 604 may include the acoustic filter 104 shown in FIG. 1 or the PA 106 shown in FIG. 1. Other examples of the electronic components 604 may include the LNA 108 shown in FIG. 1 or the switch device 110 shown in FIG. 1.

The package laminate 600 includes a metallic structure 605. In some embodiments, the metallic structure 605 is the metallic structure 116 shown in FIG. 1. The metallic structure 605 includes traces 606 that define a bounded physical area 608. The traces 606 surround an inductor coil 610 mounted on the mounting surface 602. Furthermore, traces 611, a face 612 of one of the electronic components 604 marked IR, and an edge 614 of the mounting surface 602 define a bounded physical area 616. Similarly, an edge 618 of the mounting surface 602 and traces 620 define a bounded physical area 622. Finally, a face 624 of the electronic component 604 marked IR and the edge 614 define a bounded physical area 626.

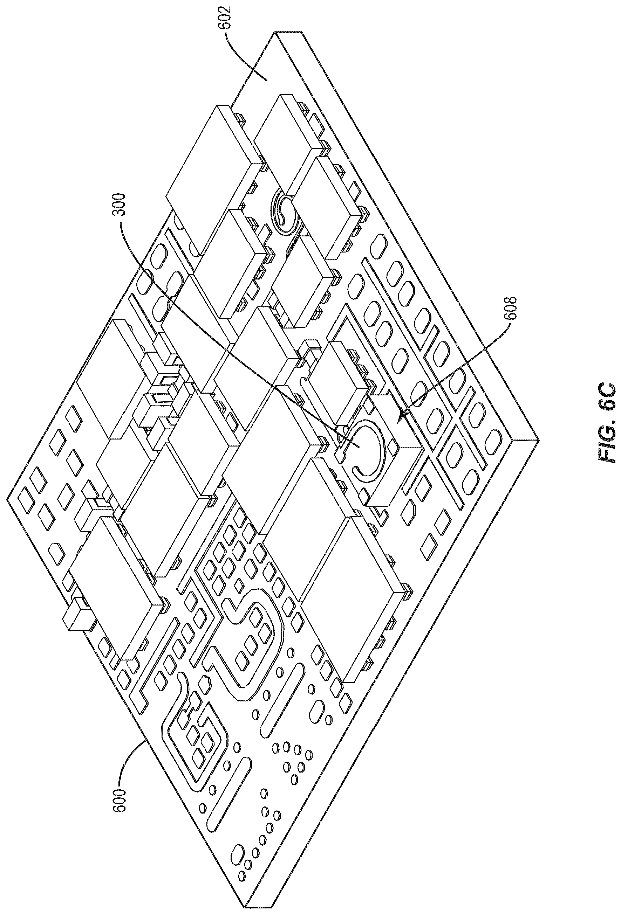

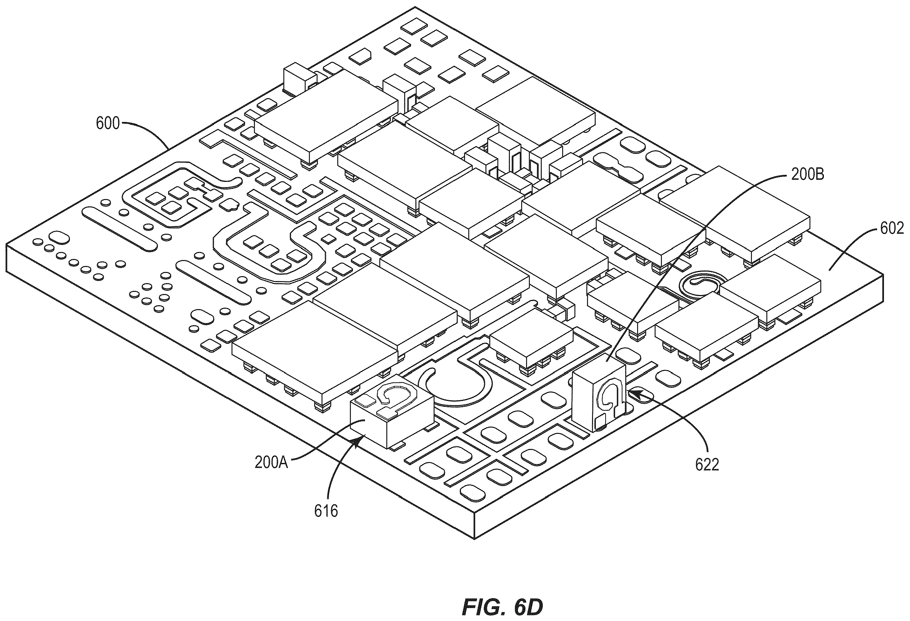

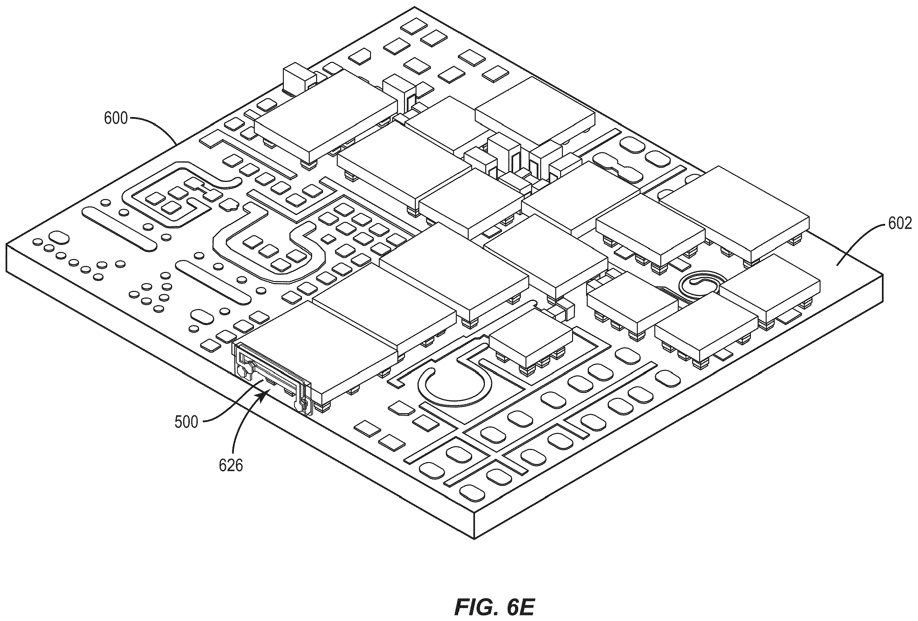

In FIG. 6A, one or more of the electronic components 604 may be acoustic filters (such as the acoustic filter 104 shown in FIG. 1) arranged in such a manner to allow a multiplexing network implemented between the electronic components 604 with laminate integrated inductors (such as the inductor coil 610), the surface mount device 300 (which will be explained in further detail below in FIG. 6C), surface mount devices 200A, 200B (which will be explained below in FIG. 6D), the surface mount device 500 (which will be explained below in FIG. 6E), and capacitors. The better the Q-factor achieved by the multiplexing elements, the lower the network losses. Therefore, in most cases, implementing those inductances on a laminate (such as the laminate substrate shown in FIG. 1, the laminate substrate shown in FIG. 2A, and the laminate 502 shown in FIG. 5) using the maximum possible volume and reducing parasitic capacitance by eliminating nearby grounds provides a best outcome. On the other hand, a large portion of the available space is consumed by the electronic components 604, which present constraints in the size as well as in the routing and implementation of other circuits needed for the system. By customizing the surface mount device 200 shown in FIGs. 2A and 2B, the surface mount device 300 in FIG. 3, the surface mount device 400 shown in FIG. 4, and the surface mount device 500 shown in FIG. 5 to occupy the available area, more compact RF package designs can be achieved while maximizing the Q-factor of the surface mount device 200 shown in FIGs. 2A and 2B, the surface mount device 300 in FIG. 3, the surface mount device 400 shown in FIG. 4, and the surface mount device 500 shown in FIG. 5.

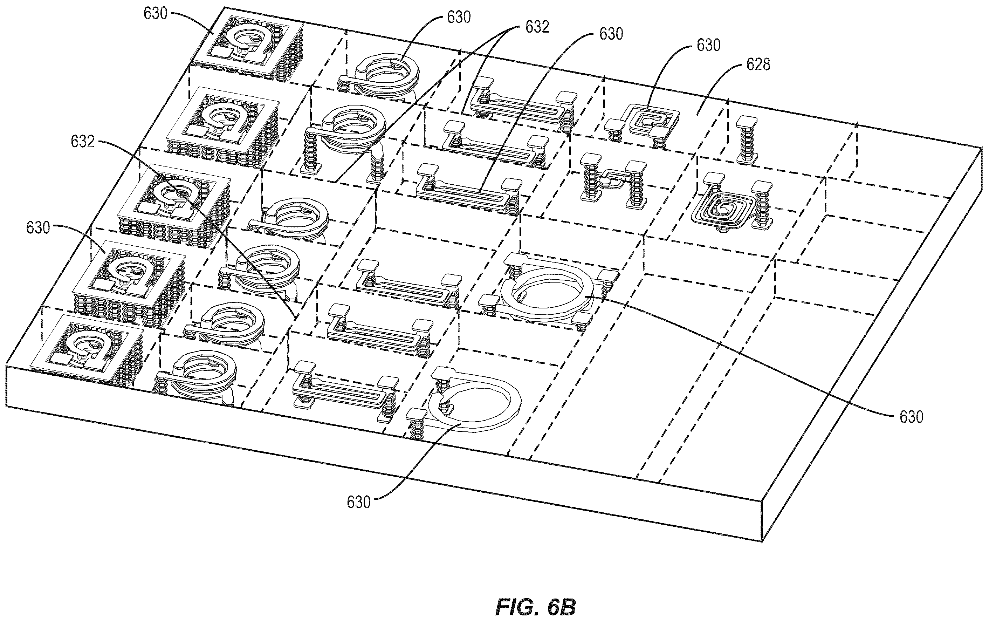

In FIG. 6B, a laminate 628 is provided, having inductors 630 (not all labeled for the sake of clarity) integrated into the laminate 628. The inductors 630 may have a variety of designs, such as the designs of the inductors 204, 402, 404 shown in FIGs. 2A, 2B, and 4, along with other designs. Each of the inductors 630 are formed in the laminate 628. The laminate 628 is then diced along dice edges 632 (not all labeled for the sake of clarity) in order to form surface mount devices, such as the surface mount device 200 shown in FIGs. 2A and 2B, the surface mount device 300 in FIG. 3, the surface mount device 400 shown in FIG. 4, and the surface mount device 500 in FIG. 5.

FIG. 6C illustrates the surface mount device 300 being mounted to the mounting surface 602 so that the surface mount device 300 occupies the bounded physical area 608, in accordance with some embodiments.

As shown in FIG. 6C, the surface mount device 300 has been dimensioned so as to fit in the bounded physical area 608. Furthermore, the surface mount device 300 is connected to the inductor coil 610 so that the inductor 204 shown in FIGs. 2A and 2B is connected to the inductor coil 610. In this manner, the surface mount device 400 shown in FIG. 4 can be used with the inductor coil 610 formed by the package laminate 600 to form inductive structures.

FIG. 6D illustrates the surface mount devices 200A, 200B being mounted to the mounting surface 602 so that the surface mount device 200A occupies the bounded physical area 616 and the surface mount device 200B occupies the bounded physical area 622, in accordance with some embodiments.

The surface mount device 200A is provided in the same manner as the surface mount device 200 shown in FIGs. 2A and 2B. Similarly, the surface mount device 200B is provided in the same manner as the surface mount device 200 shown in FIGs. 2A and 2B. The surface mount device 200A has been dimensioned to fit within the bounded physical area 616 and the surface mount device 200B has been dimensioned to fit within the bounded physical area 622.

FIG. 6E illustrates the surface mount device 500 being mounted to the mounting surface 602 so that the surface mount device 500 occupies the bounded physical area 626, in accordance with some embodiments.

The surface mount device 500 has been dimensioned to fit within the bounded physical area 626.

Note that the electronic components 604 shown in FIG. 6A have been previously mounted on the mounting surface 602. By knowing the arrangement of the electronic components 604 and the package laminate 600, the surface mount device 200 shown in FIGs. 2A and 2B, the surface mount device 300 shown in FIG. 3, the surface mount device 400 shown in FIG. 4, and the surface mount device 500 shown in FIG. 5 can be designed to fit within different areas of available space and thereby provide a more compact arrangement for an RF package formed with the package laminate 600, the electronic components 604, the surface mount device 200 shown in FIGs. 2A and 2B, the surface mount device 300 shown in FIG. 3, the surface mount device 400 shown in FIG. 4, and the surface mount device 500 shown in FIG. 5. Subsequently, an overmold (such as the overmold 122 shown in FIG. 1) (or an undermold such as the undermold 124 shown in FIG. 1) and shielding can be provided over the mounting surface 602 to form an RF package.

The application cases for the surface mount device 200 shown in FIGs. 2A and 2B, the surface mount device 300 shown in FIG. 3, the surface mount device 400 shown in FIG. 4, and the surface mount device 500 shown in FIG. 5, along with other devices within the scope of this disclosure are various. For example, custom coils in surface mount devices can be designed with a custom size, a nominal value, and an improved Q-factor, along with shielding. Surface mount devices with multiplexing coils can be formed on a multiplexing coil on the package laminate (see, for example, the inductor coil 610 shown in FIG. 6A). Also, the thermal behavior of acoustic filters can be improved by replacing integrated ground coils with surface mount devices having custom coils in a laminate allowing more space to be used for thermal vias. Isolation improvement can be achieved due to custom coil design (field radiation generated outside the inductor can be easily controlled). Finally, coupled inductors and impedance transformers (for PA output matching, etc.) can be designed in surface mount devices.

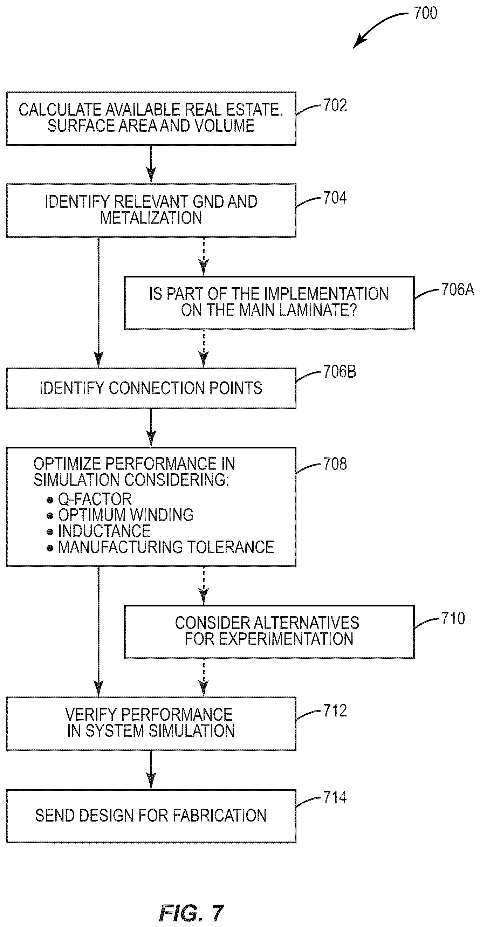

FIG. 7 is a flow chart 700 of method of designing a surface mount device, in accordance with some embodiments.

In some embodiments, the surface mount devices 102 in FIG. 1, the surface mount device 200 in FIG. 2 (including surface mount devices 200A, 200B in FIG. 6D), the surface mount device 300 in FIG. 3, the surface mount device 400 in FIG. 4, and the surface mount device 500 in FIG. 5 may be designed in accordance with flow chart 700.

At block 702, an available surface area for fitting in silico surface mount devices is defined based on spacing to adjacent in silico components on the an in silico package substrate of an in silico RF package and a height of the in silico surface mount device. At block 704, in silico grounds and components of an in silico metallic structure surrounding the available surface area are identified so that the performance of an in silico inductor of the in silico surface mount device can be optimized by reducing (for example, eliminating) parasitic capacitance. For example, by identifying the surrounding in silico grounds and components of an in silico metallic structure, designs rules, clearance, parasitics, couplings, ground paths, and other characteristics of the identified in silico grounds and in silico metallic structure can be considered and used in electromagnetic simulations and calculations for optimizing the in silico surface mount device. At block 706A and block 706B, it is determined whether the in silico inductor of the in silico surface mount device will be used in combination with one or more in silico windings of the in silico package substrate (block 706A) or whether the in silico inductor will be without in silico windings in the in silico package substrate (block 706B). The electrically connected points are also a parameter to be accounted for in the design process.

At block 708, electromagnetic simulations of in silico surface mount device from a data library are performed, and one or more candidate in silico surface mount devices are selected based on the electromagnetic simulations. When performing the electromagnetic simulation, the in silico surface mount device from the data library is dimensioned to fit within the available surface area. In particular, the electromagnetic simulations are used to select the one or more candidate in silico surface mount devices that have the most optimal characteristics in terms of performance parameters when compared with design specifications. Performance parameters that may be considered are a Q-factor, winding orientation, inductance, and manufacturing tolerance. When considering the performance of in silico surface mount devices in the data library and comparing them to design specifications, trade-offs can be programmed regarding how the performance during simulations meets the design specifications on a system level. More than one in silico surface mount device from the system library may have performance parameters considered to meet design specifications within design tolerances. The one or more candidate in silico surface mount devices have been dimensioned so as to fit within the available surface area. In the case of more than one suitable candidate in silico surface mount device, the designer, at block 710, selects at least one of the one or more candidate surface mount devices to be used for empirical verification. In this manner, the designer is selecting which of the candidate surface mount devices will be used to design experiments for physical surface mount devices formed in accordance with the candidate in silico surface mount device. The physical surface mount devices can then be further evaluated through additional simulations or in laboratory characterization (i.e., design of experiments). In block 712, (one or more) physical surface mount devices are formed in accordance with the selected in silico surface mounted device are experimentally verified to determine whether the (at least one of) physical surface mount devices meet the design specifications. These physical surface mount devices are dimensioned to fit within the available physical area. Examples of design specifications include system losses, ISO/LKG performance, manufacturing stability, cost, and/or the like. At block 714, the in silico surface mount devices that are experimentally verified are manufactured into physical surface mount devices to manufacture RF packages.

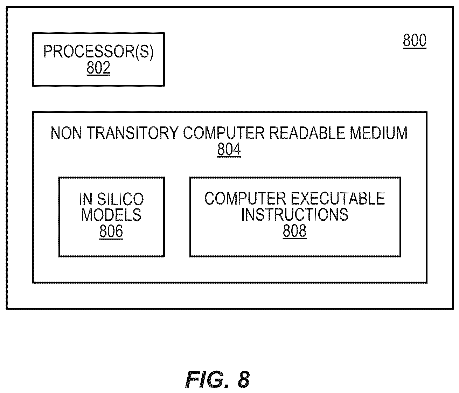

FIG. 8 is an embodiment of a computer device 800, in accordance with some embodiments.

The computer device 800 includes one or more processors 802 and one or more computer readable mediums 804 (e.g., memory). A computer readable medium such as a memory that stores instructions and/or data may be referred to as computer readable storage mediums and/or as non-transitory computer readable mediums. The computer readable mediums 804 store in silico models 806 and computer executable instructions 808. The in silico models 806 include the in silico surface mount device models, in silico substrate packages, and the in silico package RF packages discussed above in FIG. 7. In response to executing the computer executable instructions 808, the processors 802 perform the method described above in FIG. 7. The in silico models 806 and/or computer executable instructions 808 may be provided to the computer device 800 (and/or moved between elements within the computer device 800) by way of a computer readable transmission medium. A computer-readable transmission medium may include carrier waves, transmission signals or the like.

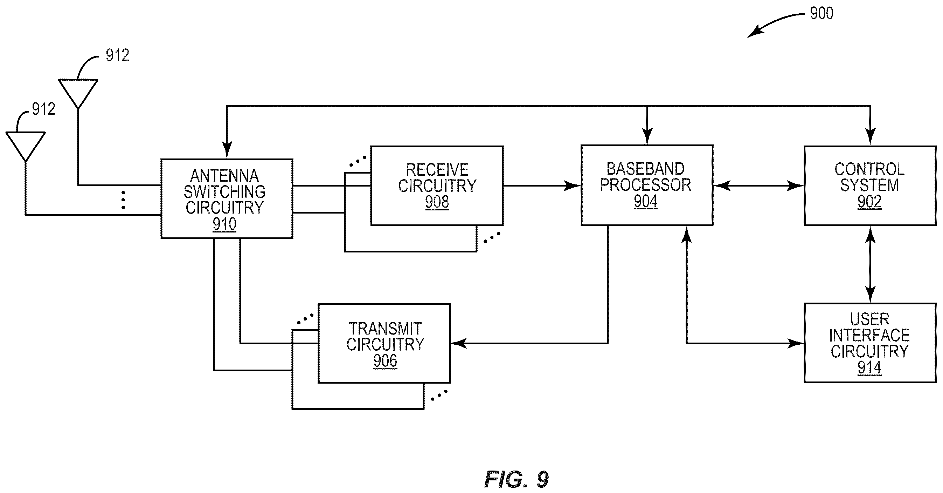

FIG. 9 illustrates a user element 900 in accordance with some embodiments.

With reference to FIG. 9, the concepts described above may be implemented in various types of user elements 900, such as mobile terminals, smart watches, tablets, computers, navigation devices, access points, and like wireless communication devices that support wireless communications, such as cellular, wireless local area network (WLAN), Bluetooth, and near field communications. The user element 900 will generally include a control system 902, a baseband processor 904, transmit circuitry 906, receive circuitry 908, antenna switching circuitry 910, multiple antennas 912, and user interface circuitry 914. In a non-limiting example, the control system 902 may be a field-programmable gate array (FPGA) or an application-specific integrated circuit (ASIC). In this regard, the control system 902 may include at least a microprocessor(s), an embedded memory circuit(s), and a communication bus interface(s). The receive circuitry 908 receives radio frequency signals via the antennas 912 and through the antenna switching circuitry 910 from one or more base stations. An LNA and a filter cooperate to amplify and remove broadband interference from the received signal for processing. Downconversion and digitization circuitry (not shown) will then downconvert the filtered, received signal to an intermediate or baseband frequency signal, which is then digitized into one or more digital streams using analog-to-digital converters (ADCs).

The baseband processor 904 processes the digitized received signal to extract the information or data bits conveyed in the received signal. This processing typically comprises demodulation, decoding, and error correction operations, as will be discussed in greater detail below. The baseband processor 904 is generally implemented in one or more digital signal processors (DSPs) and application specific integrated circuits (ASICs).

For transmission, the baseband processor 904 receives digitized data, which may represent voice, data, or control information, from the control system 902, which it encodes for transmission. The encoded data is output to the transmit circuitry 906, where a digital-to-analog converter (DAC) converts the digitally encoded data into an analog signal and a modulator modulates the analog signal onto a carrier signal that is at a desired transmit frequency or frequencies. A PA will amplify the modulated carrier signal to a level appropriate for transmission and deliver the modulated carrier signal to the antennas 912 through the antenna switching circuitry 910. The multiple antennas 912 and the replicated transmit circuit 906 and receive circuit 908 may provide spatial diversity. Modulation and processing details will be understood by those skilled in the art.

Therefore, from one perspective, there have been described approaches for a radio frequency (RF) package that include a package laminate and a surface mount device mounted to a mounting surface of the package laminate. The package laminate includes a first laminate substrate and a metallic structure integrated with the first laminate substrate. An electronic component is mounted to the mounting surface of the first laminate substrate. The surface mount device includes a second laminate substrate and an inductor integrated with the second laminate substrate. A bounded physical area is defined by at least one of a surface of the electronic component and the metallic structure that defines a boundary of the bounded physical area. The surface mount device is dimensioned so as to fit within the bounded physical area. In this manner, the surface mount device allows for a more compact RF package with a higher quality factor.

Further examples of feature combinations taught by the present disclosure are set out in the following numbered clauses.

Clause 1. A radio frequency (RF) package, comprising: a package laminate, comprising: a first laminate substrate defining a mounting surface; and a metallic structure integrated with the first laminate substrate; an electronic component mounted to the mounting surface of the first laminate substrate; a surface mount device mounted to the mounting surface, the surface mount device comprising: a second laminate substrate; and an inductor integrated with the second laminate substrate; and a bounded physical area defined by at least one of a surface of the electronic component and the metallic structure that defines a boundary of the bounded physical area, the surface mount device being dimensioned so as to fit within the bounded physical area.

Clause 2. The RF package of clause 1, wherein: the bounded physical area is bound by one or more traces formed by the metallic structure; the mounting surface is a first mounting surface; the second laminate substrate defines a second mounting surface; and the surface mount device being dimensioned so as to fit within the bounded physical area includes having the second mounting surface being dimensioned so as to fit within the bounded physical area.

Clause 3. The RF package of clause 2, wherein: the metallic structure defines a first inductor coil; and the surface mount device is mounted to the first mounting surface over the first inductor coil.

Clause 4. The RF package of clause 3, wherein the inductor defines a second inductor coil, wherein a first shape of the first inductor coil is a same shape as a second shape of the second inductor coil.

Clause 5. The RF package of any preceding clause, wherein: the bounded physical area is bound by a first vertical surface of the electronic component; the surface mount device defines a second vertical surface; and the surface mount device being dimensioned so as to fit within the bounded physical area includes having the second vertical surface being dimensioned so as to fit within the first vertical surface.

Clause 6. The RF package of clause 5, wherein the electronic component comprises an acoustic filter.

Clause 7. The RF package of any preceding clause, wherein the inductor comprises a plurality of inductor coils, each of the plurality of inductor coils is formed in a different metallic layer within the second laminate substrate.

Clause 8. The RF package of any preceding clause, wherein the surface mount device further comprises a metallic Faraday cage that surrounds the inductor.

Clause 9. The RF package of any preceding clause, wherein: the inductor is a first inductor; and the surface mount device further comprises a second inductor configured to be electromagnetically coupled to the first inductor so as to form a transformer or a balun.

Clause 10. The RF package of any preceding clause, further comprising an overmold formed over the mounting surface so as to cover the surface mount device.

Clause 11. A method of manufacturing a radio frequency (RF) package, comprising: providing a laminate having an inductor integrated into the laminate; dicing the laminate to provide form a surface mount device with a device laminate that includes the inductor, the surface mount device being dimensioned so as to fit within a bounded physical area; mounting an electronic component on a mounting surface of a package laminate, a metallic structure being integrated into the package laminate; and mounting the surface mount device to the mounting surface, wherein the bounded physical area is defined by at least one of a surface of the electronic component and the metallic structure that defines a boundary of the bounded physical area.

Clause 12. A user element comprising a radio frequency (RF) package, the RF package comprising: a package laminate, comprising: a first laminate substrate defining a mounting surface; and a metallic structure integrated with the first laminate substrate; an electronic component mounted to the mounting surface of the first laminate substrate; a surface mount device mounted to the mounting surface, the surface mount device comprising: a second laminate substrate; and an inductor integrated with the second laminate substrate; and a bounded physical area defined by at least one of a surface of the electronic component and the metallic structure that defines a boundary of the bounded physical area, the surface mount device being dimensioned so as to fit within the bounded physical area.

Clause 13. The user element of clause 12, wherein: the bounded physical area is bound by one or more traces formed by the metallic structure; the mounting surface is a first mounting surface; the second laminate substrate defines a second mounting surface; and the surface mount device being dimensioned so as to fit within the bounded physical area includes having the second mounting surface being dimensioned so as to fit within the bounded physical area.

Clause 14. The user element of clause 13, wherein: the metallic structure defines a first inductor coil; and the surface mount device is mounted to the first mounting surface over the first inductor coil.

Clause 15. The user element of clause 14, wherein the inductor defines a second inductor coil, wherein a first shape of the first inductor coil is a same shape as a second shape of the second inductor coil.

Clause 16. The user element of any of clauses 12 to 15, wherein: the bounded physical area is bound by a first vertical surface of the electronic component; the surface mount device defines a second vertical surface; and the surface mount device being dimensioned so as to fit within the bounded physical area includes having the second vertical surface being dimensioned so as to fit within the first vertical surface.

Clause 17. The user element of clause 16, wherein the electronic component comprises an acoustic filter.

Clause 18. The user element of any of clauses 12 to 17, wherein the inductor comprises a plurality of inductor coils, each of the plurality of inductor coils is formed in a different metallic layer within the second laminate substrate.

Clause 19.The user element of any of clauses 12 to 18, wherein the surface mount device further comprises a metallic Faraday cage that surrounds the inductor.

Clause 20. The user element of any of clauses 12 to 19 , wherein: the inductor is a first inductor; and the surface mount device further comprises a second inductor configured to be electromagnetically coupled to the first inductor so as to form a transformer or a balun.

Clause 21. A method of designing a surface mount device, the method comprising: defining an available surface area for fitting an in silico surface mount device based on adjacent in silico components on the an in silico package substrate of an in silico RF package; identifying in silico grounds and components of an in silico metallic structure surrounding the available surface area so that a performance of an in silico inductor of the in silico surface mount device can be optimized by reducing parasitic capacitance; performing electromagnetic simulations of in silico surface mount devices from a data library to select one or more candidate in silico surface mount devices based on the electromagnetic simulations. wherein each of the one or more candidate in silico surface mount devices has been dimensioned to fit within the available physical area; and empirically verifying at least one physical surface mount device that is formed in accordance with at least one of the one or more candidate in silico surface mount devices to determine whether the at least one physical surface mount device meets the design specifications.

Those skilled in the art will recognize improvements and modifications to the above-described embodiments of the present disclosure. All such improvements and modifications are considered within the scope of the concepts disclosed herein and the claims that follow.

## Claims

1. A radio frequency (RF) package, comprising:
a package laminate, comprising:
a first laminate substrate defining a mounting surface; and
a metallic structure integrated with the first laminate substrate;
an electronic component mounted to the mounting surface of the first laminate substrate;
a surface mount device mounted to the mounting surface, the surface mount device comprising:
a second laminate substrate; and
an inductor integrated with the second laminate substrate; and
a bounded physical area defined by at least one of a surface of the electronic component and the metallic structure that defines a boundary of the bounded physical area, the surface mount device being dimensioned so as to fit within the bounded physical area.

2. The RF package of claim 1, wherein:
the bounded physical area is bound by one or more traces formed by the metallic structure;
the mounting surface is a first mounting surface;
the second laminate substrate defines a second mounting surface; and
the surface mount device being dimensioned so as to fit within the bounded physical area includes having the second mounting surface being dimensioned so as to fit within the bounded physical area.

3. The RF package of claim 2, wherein:
the metallic structure defines a first inductor coil; and
the surface mount device is mounted to the first mounting surface over the first inductor coil.

4. The RF package of claim 3, wherein the inductor defines a second inductor coil, wherein a first shape of the first inductor coil is a same shape as a second shape of the second inductor coil.

5. The RF package of any preceding claim, wherein:
the bounded physical area is bound by a first vertical surface of the electronic component;
the surface mount device defines a second vertical surface; and
the surface mount device being dimensioned so as to fit within the bounded physical area includes having the second vertical surface being dimensioned so as to fit within the first vertical surface.

6. The RF package of claim 5, wherein the electronic component comprises an acoustic filter.

7. The RF package of any preceding claim, wherein the inductor comprises a plurality of inductor coils, each of the plurality of inductor coils is formed in a different metallic layer within the second laminate substrate.

8. The RF package of any preceding claim, wherein the surface mount device further comprises a metallic Faraday cage that surrounds the inductor.

9. The RF package of any preceding claim, wherein:
the inductor is a first inductor; and
the surface mount device further comprises a second inductor configured to be electromagnetically coupled to the first inductor so as to form a transformer or a balun.

10. The RF package of any preceding claim, further comprising an overmold formed over the mounting surface so as to cover the surface mount device.

11. A user element comprising the RF package of any of claims 1 to 10.

12. A method of manufacturing a radio frequency (RF) package, comprising:
providing a laminate having an inductor integrated into the laminate;
dicing the laminate to provide form a surface mount device with a device laminate that includes the inductor, the surface mount device being dimensioned so as to fit within a bounded physical area;
mounting an electronic component on a mounting surface of a package laminate, a metallic structure being integrated into the package laminate; and
mounting the surface mount device to the mounting surface, wherein the bounded physical area is defined by at least one of a surface of the electronic component and the metallic structure that defines a boundary of the bounded physical area.

13. A method of designing a surface mount device, the method comprising:
defining an available surface area for fitting an in silico surface mount device based on adjacent in silico components on the an in silico package substrate of an in silico RF package;
identifying in silico grounds and components of an in silico metallic structure surrounding the available surface area so that a performance of an in silico inductor of the in silico surface mount device can be optimized by reducing parasitic capacitance;
performing electromagnetic simulations of in silico surface mount devices from a data library to select one or more candidate in silico surface mount devices based on the electromagnetic simulations. wherein each of the one or more candidate in silico surface mount devices has been dimensioned to fit within the available physical area; and
empirically verifying at least one physical surface mount device that is formed in accordance with at least one of the one or more candidate in silico surface mount devices to determine whether the at least one physical surface mount device meets the design specifications.
